# EUROPÄISCHE PATENTSCHRIFT

(11) **EP 3 066 480 B1**
(45) Veröffentlichungstag und Bekanntmachung des Hinweises auf die Patenterteilung: **28.02.2018**
(21) Anmeldenummer: 13792622.6
(22) Anmeldetag: 07.11.2013
(51) Int. Cl.: G01R 1/067

(54) **PRÜFNADEL UND VERFAHREN ZUR HERSTELLUNG EINER PRÜFNADEL**
TEST NEEDLE AND METHOD FOR PRODUCING A TEST NEEDLE
AIGUILLE DE TEST ET SON PROCÉDÉ DE FABRICATION

(43) Veröffentlichungstag der Anmeldung: 14.09.2016
(73) Patentinhaber: Heraeus Deutschland GmbH & Co. KG, 63450 Hanau (DE)
(72) Erfinder: SOERENSEN, Per, 63505 Langenselbold (DE); STAUDT, Nicole, 61169 Friedberg (DE); WEILAND, Reinhold, 63454 Hanau (DE); PRUNZEL, Ingo, 63486 Bruchköbel (DE); LUPTON, David Francis, 63571 Gelnhausen (DE)
(74) Vertreter: Heraeus IP
(86) Internationale Anmeldenummer: PCT/EP2013/073267
(87) Internationale Veröffentlichungsnummer: WO 2015/067312

(56) Entgegenhaltungen:
- US-A1- 2002 113 612
- US-A1- 2010 239 453
- US-A1- 2013 271 173
- "BINARY ALLOY PHASE DIAGRAM, Zr-Rh Phase Diagram ED - Massalski Tadeusz B; Okamoto Hiroaki; Subramanian P R; Kacprzak Linda", 30. Dezember 1990 (1990-12-30), BINARY ALLOY PHASE DIAGRAM, ASM INTERNATIONAL, MATERIALS PARK, OHIO, PAGE(S) 3249, XP002714038, ISBN: 978-0-87170-406-1 das ganze Dokument

## Beschreibung

Die Erfindung betrifft eine Prüfnadel zur elektronischen Prüfung von Halbleiterelementen, umfassend ein elektrisch leitendes Kernelement, wobei das Kernelement aus einer metallischen Legierung aufgebaut ist und ein elektrisch isolierendes Mantelelement, wobei das Mantelelement das Kernelement bereichsweise umschließt und das Kernelement einen distalen Kontaktabschnitt zur elektrischen Kontaktierung mit dem Halbleiterelement aufweist. Weiterhin betrifft die Erfindung ein Verfahren zur Herstellung einer Prüfnadel.

Während der Chipproduktion werden Halbleiterelemente direkt nach der Prozessierung mit Prüfnadeln kontaktiert, um die Funktionsfähigkeit der integrierten Schaltungen (IC) in ungesägtem Zustand der Halbleiterelemente zu testen. Die Prüfnadeln sind in einer Testkarte (probe card) fixiert, die auf das Design des Halbleiterelements abgestimmt ist. Beim Prüfprozess wird das Halbleiterelement auf die Nadeln gepresst und eine Kontaktierung zwischen Nadeln und den Pads der ICs, gegebenenfalls durch eine Passivierungsschicht hindurch, hergestellt. Daraufhin werden verschiedene Parameter getestet, wie zum Beispiel die Kontaktierung, das Durchgangsverhalten bei hoher Stromdichte und das elektrische Verhalten bei Temperaturwechseln.

Die Prüfnadeln müssen eine hohe elektrische Leitfähigkeit und hohe Wärmeleitfähigkeit, eine gute Korrosionsbeständigkeit, darüber hinaus eine große Härte, aber auch gute Federeigenschaften aufweisen. Die Zunahme der Härte zahlreicher Werkstoffe geht oft mit der Zunahme der Sprödigkeit einher, was nachteilig für die Federeigenschaften und hinsichtlich der Verarbeitbarkeit ist.

Aufgrund der jüngsten Entwicklung zur fortschreitenden Miniaturisierung der ICs auf den Halbleiterelementen müssen stetig dichter gepackte Anordnungen der Prüfnadeln auf der Prüfkarte realisiert werden. Somit bedarf es immer dünnerer Prüfnadeln. Um diesen Anforderungen zu genügen, müssen die zur Herstellung der Prüfnadeln eingesetzten Materialien eine große Härte und gute Federeigenschaften aufweisen und zu dünnen Drähten verarbeitbar sein.

Für das Testen auf Aluminiumpads sind Prüfnadeln auf Wolfram-Basis bekannt. Wolfram und Wolfram-Legierungen und -Keramiken sind ausgesprochen hart und daher für die Kontaktierung von Aluminiumpads geeignet, da die bei Aluminiumpads omnipräsente Oxid- oder Passivierungsschicht zunächst durchstoßen werden muss. Wolfram ist jedoch oxidationsempfindlich. Die gebildeten Wolframoxide haften an den Aluminiumpads und führen so zu unerwünschten Kontaminationen im Bereich der Kontaktierung.

Für die Prüfung auf Goldpads ist Wolfram weniger gut geeignet, da Goldpads weniger robust sind als Aluminiumpads und der Prüfung mit Wolfram aufweisenden Prüfnadeln mechanisch oft nicht standhalten.

Für die Anwendung auf Goldpads sind Pd-Legierungen bekannt, wie beispielsweise Paliney® H3C der Firma Deringer Ney oder NewTec® der Firma Advanced Probing. Palladium hat den Nachteil, dass aufwändige Umformprozesse und Ausscheidungshärtungen zur Herstellung geeigneter Palladium-Legierungen erforderlich sind. Dadurch wird die Anzahl der notwendigen Produktionsschritte erhöht. Zusätzlich hat Palladium eine den Anforderungen nur gerade genügende elektrische Leitfähigkeit.

Die US 2006/0197542 A1 und die US 2010/0239453 A1 offenbaren Legierungen auf IridiumBasis zur Verwendung als Prüfnadeln. Iridium weist eine niedrigere thermische und elektrische Leitfähigkeit als andere Platinmetalle auf, ist spröde und unelastisch und daher schwer zu bearbeiten. Die Druckschriften "BINARY ALLOY PHASE DIAGRAM, Zr-Rh Phase Diagram ED - Massalski Tadeusz B; Okamoto Hiroaki; Subramanian P R; Kacprzak Linda", 30. Dezember 1990 und US 2002/113612 A1 offenbaren Legierungen auf Rhodium und Zirkonium Basis. Es ist somit die Aufgabe der vorliegenden Erfindung, die Nachteile des Standes der Technik zu überwinden. Insbesondere ist es die Aufgabe der Erfindung, ein Material zu finden, das im Gegensatz zu vielen Legierungen auf Palladium und/oder Platin-Basis ausreichend hart ist, um der millionenfachen Prüfung auf ICs standzuhalten und über eine bessere thermische und elektrische Leitfähigkeit als Palladium und Platin oder entsprechende Legierungen verfügt. Dabei sollte das Material im Gegensatz zu Wolfram, das zwar die erforderliche Härte aufweist, oxidationsbeständig sein. Weiterhin sollte das Material gut zu dünnen Prüfnadeln verarbeitbar sein, um der Anforderung der hohen Packungsdichte auf Prüfkarten zu genügen.

Zur Lösung dieser Aufgabe wird eine Prüfnadel zur elektronischen Prüfung von Halbleiterelementen mit den Merkmalen des Anspruchs 1 vorgeschlagen. Weiterhin wird zur Lösung der Aufgabe ein Verfahren zur Herstellung einer Prüfnadel zur elektronischen Prüfung von Halbleiterelementen mit den Merkmalen des Anspruchs 11 vorgeschlagen. In den abhängigen Ansprüchen sind jeweils bevorzugte Weiterbildungen ausgeführt. Merkmale und Details, die in Zusammenhang mit der Prüfnadel beschrieben werden, gelten dabei auch in Zusammenhang mit dem Verfahren und umgekehrt.

Die erfindungsgemäße Prüfnadel zeichnet sich dadurch aus, dass die metallische Legierung des Kernelements aufweist:
- wenigstens 67 Gew.-% Rhodium,
- 0,1 Gew.-% bis 1 Gew.-% Zirkonium,
- bis zu 1 Gew.-% Yttrium und
- bis zu 1 Gew.-% Cer.

Iridium und andere Platinmetalle haben gegenüber Rhodium den Nachteil, dass diese über geringere elektrische Leitfähigkeiten und Wärmeleitfähigkeiten verfügen. Eine hohe elektrische Leitfähigkeit und Wärmeleitfähigkeit sind für den Einsatz in Prüfnadeln gewünschte Eigenschaften, die von Rhodium erfüllt werden.

Reines Rhodium weist ein hohes Elastizitätsmodul auf und zeigt im Einsatz für Prüfnadeln ein zu plastisches Verhalten. Deshalb wurde vorgeschlagen, Rhodium mit Iridium zu legieren. Bei Anteilen von größer 30 Gew.-% Rhodium wird die Verarbeitbarkeit des Materials zu dünnen Drähten jedoch schwierig und es ist mit häufigen Drahtabrissen zu rechnen.

Überraschenderweise hat sich gezeigt, dass Rhodium mit Zirkonium-Anteilen von 0,1 Gew.-% bis 1 Gew.-% erfindungsgemäß noch zu dünnen Drähten verarbeitbar ist und die gegenüber Iridium bestehenden Vorteile hinsichtlich der thermischen und elektrischen Leitfähigkeit und des weitaus geringeren Elastizitätsmoduls, also besserer Federeigenschaften, erhalten bleiben.

Es hat sich gezeigt, dass metallische Legierungen auf Basis von Rhodium mit einem Rhodiumanteil von wenigstens 67 Gew.-% Rhodium und einem Zirkoniumanteil von 0,1 Gew.-% bis 1 Gew.-% Zirkonium einfach zu dünnen Drähten verarbeitbar sind und dadurch metallische Legierungen zur Verwendung als Kernelement für Prüfnadeln zugänglich werden, die die Vorteile von reinem Rhodium hinsichtlich Härte, thermischer Leitfähigkeit und elektrischer Leitfähigkeit und niedrigem Elastizitätsmodul für Prüfnadeln zur elektronischen Prüfung von Halbleiterelementen nutzbar machen.

Durch die mit der Zulegierung von Zirkonium zu Rhodium einhergehende Kornfeinung des Metallgefüges wird das Kornwachstum bei Temperaturen über 150 °C behindert und somit überraschenderweise eine gute Verformbarkeit der metallischen Legierung bis zu Durchmessern von 50 µm bis 100 µm erreicht. Weiterhin wird durch das Zulegieren von Zirkonium und optional Yttrium und Cer eine im Gegensatz zu reinem Rhodium aushärtbare metallische Legierung zur Herstellung des Kernelements der Prüfnadel erzeugt. Nach der Verformung an den Zieldurchmesser kann das Material durch eine einfache Temperaturbehandlung ausgehärtet werden, was preiswert realisierbar ist.

Dabei ist die Härte der erfindungsgemäßen metallischen Legierung auf Basis von Rhodium so einstellbar, dass eine geringe oder keine Beschädigung von Goldpads sichergestellt werden kann. Erfindungsgemäße Prüfnadeln zur Kontaktierung von Goldpads weisen eine Härte von 400 HV bis 650 HV auf. Gleichzeitig ist eine große Härte der metallischen Legierung zum Einsatz in Prüfnadeln für Aluminiumpads einstellbar. Erfindungsgemäße Prüfnadeln zur Kontaktierung von Aluminiumpads weisen eine Härte von 500 HV bis 750 HV auf. Weiterhin ist eine einfache Verarbeitung möglich, mit der Drähte mit Durchmessern von 50 µm bis 150 µm beispielsweise von 80 µm in einem Standardprozess gefertigt werden können, ohne mit Drahtabrissen rechnen zu müssen. Gleichzeitig sind die Prüfnadeln mit hoher Geradheit herstellbar, um eine exakte Kontaktierung der Kontakte (Goldpads oder Aluminiumpads) zu ermöglichen. Gleichzeitig verfügen erfindungsgemäße Prüfnadeln über ausreichende Federeigenschaften, damit sich die Prüfnadeln bei der Kontaktierung nicht plastisch verformen und dadurch der Kontakt zwischen Prüfnadel und Kontaktpad stabilisiert und die Abnutzung der Prüfnadel minimiert wird.

Nicht zuletzt haben die für das Kernelement beschriebenen metallischen Legierungen den großen Vorteil, ätzbar zu sein. Die Ätzbarkeit dünner Rhodiumschichten ist bei der Herstellung der Prüfnadeln zur Ausformung der Spitze vorteilhaft. Ätzmedien für das Strukturieren von dünnen Rhodiumschichten kennt der Fachmann aus dem Stand der Technik.

Im Rahmen der Erfindung bezeichnet der Begriff "Kernelement" den im Querschnitt betrachtet inneren Teil einer Prüfnadel, wobei das Kernelement elektrisch leitend ist und länglich ausgebildet ist. Das Kernelement ist aus der metallischen Legierung aufgebaut, insbesondere weist das Kernelement wenigstens 67 Gew.-% Rhodium, 0,1 bis 1 Gew.-% Zirkonium, bis zu 1 Gew.-% Yttrium und bis zu 1 Gew.-% Cer auf.

Im Rahmen der Erfindung bezeichnet der Begriff "Halbleiterelement" ein schichtweise aufgebautes System von integrierten Schaltkreisen auf einem Substratkörper. Von dem Begriff umfasst ist ebenfalls ein stromleitendes Mittel, welches auf dem schichtweise aufgebauten System von integrierten Schaltkreisen aufgebracht ist und zur Verbindung mit Leitungselementen wie z.B. Bonddrähten, ribbons dient. Damit ist insbesondere ein Kontaktpad oder ein Wafer umfasst.

Der Begriff "Mantelelement" bezeichnet ein im Querschnitt betrachtet das Kernelement wenigstens teilweise umschließendes Element, wobei das Mantelelement elektrisch isolierend ist.

Der "distale Kontaktabschnitt" ist derjenige Endbereich des Kernelements, über welchen bei der elektronischen Prüfung des Halbleiterelements die Kontaktierung zwischen Prüfnadel und Kontaktpad auf dem Halbleiterelement hergestellt wird. In einer Ausführungsform weist der distale Kontaktabschnitt eine Spitze auf, die der eigentlichen Kontaktierung des distalen Kontaktabschnitts auf dem Kontaktpad dient.

Die "Korngröße" bezeichnet den Durchmesser der Körner des Metallgefüges, wobei die Messung des Durchmessers quer zur Längsachse des Kernelements erfolgt.

"Kornfeinung" bezeichnet die Eigenschaft von Metallen und metallischen Legierungen, dass durch das Zulegieren eines bestimmten Elements oder bestimmter Elemente zu einem Metall oder einer Metalllegierung eine Veränderung der Korngrößen des Metallgefüges des Metalls oder der Metalllegierung hin zu kleineren Korngrößen beobachtet wird.

"Ziehharter Zustand" bezeichnet den Zustand der metallischen Legierung nach dem Verformen, beispielsweise dem Ziehen ausgehend von einem Ingot zu einem Draht. Bei der Kaltverformung von Metallen oder Metalllegierungen verzerren sich die Kristallgitter der Metalle oder metallischen Legierungen, wodurch die Festigkeit des Metalls oder der Metalllegierung zunimmt, die Verformbarkeit aber abnimmt.

"Wärmebehandelter Zustand" meint den Zustand der metallischen Legierung nach einer Temperaturbehandlung. Durch die Temperaturbehandlung einer kaltverformten Legierung entsteht wenigstens teilweise ein neues Metallgefüge, wodurch die ursprünglichen Eigenschaften der Legierung vor der Kaltverformung wenigstens teilweise wieder hergestellt werden.

Unter "Temperaturbehandlung" ist die Behandlung der metallischen Legierung bei erhöhter Temperatur gemeint, wobei "erhöhte Temperatur" eine Temperatur von wenigstens 150 °C bezeichnet.

"Überkoppeln" meint das in der Elektrotechnik bekannte Phänomen der gegenseitigen Beeinflussung parallel verlaufender Leitungen. Durch Überkoppeln - auch Nebensprechen, Übersprechen oder Crosstalk genannt - stören sich unterschiedliche Leitungen gegenseitig.

Überkoppeln führt zur Störung von Signalen bei unmittelbar benachbart angeordneten Prüfnadeln.

Eine bevorzugte Ausführungsform der Prüfnadel zeichnet sich dadurch aus, dass die metallische Legierung des Kernelements wenigstens 97 Gew.-% Rhodium umfasst. Bei einem hohen Rhodiumanteil des Kernelements der Prüfnadel kommen die guten Basiseigenschaften von reinem Rhodium hinsichtlich der hohen Wärmeleitfähigkeit, der hohen elektrischen Leitfähigkeit, hoher Elastizität und der großen Härte zum Tragen. In Kombination mit einem Zirkonium-Anteil von 0,1 Gew.-% bis 1 Gew.-% lassen sich darüber hinaus einfach dünne und aushärtbare Drähte zur Herstellung erfindungsgemäßer Prüfnadeln erzeugen.

In einer weiteren bevorzugten Ausführungsform der Prüfnadel ist vorgesehen, dass die metallische Legierung des Kernelements eine der folgenden Zusammensetzungen aufweist:
- Die metallische Legierung besteht aus 0,1 bis 1 Gew.-% Zirkonium und der Rest besteht aus Rhodium.
- Die metallische Legierung besteht aus 0,1 bis 1 Gew.-% Zirkonium, 0,001 Gew.-% bis 1 Gew.-% Yttrium und der Rest besteht aus Rhodium.
- Die metallische Legierung besteht aus 0,1 bis 1 Gew.-% Zirkonium, 0,001 Gew.-% bis 1 Gew.-% Cer und der Rest besteht aus Rhodium.
- Die metallische Legierung besteht aus 0,1 bis 1 Gew.-% Zirkonium, 0,001 Gew.-% bis 1 Gew.-% Cer und 0,001 Gew.-% bis 1 Gew.-% Yttrium und der Rest besteht aus Rhodium.

Diese Zusammensetzungen erfindungsgemäßer metallischer Legierungen haben sich als besonders günstig hinsichtlich der für Prüfnadeln wichtigen genannten Eigenschaften erwiesen.

Eine weitere bevorzugte Ausführungsform der Prüfnadel sieht vor, dass die metallische Legierung des Kernelements 0,2 Gew.-% bis 0,6 Gew.-% Zirkonium umfasst. Diese Zusammensetzungen bewirken eine gute nachträgliche Aushärtbarkeit der das Kernelement bildenden metallischen Legierung, sodass die Härte zu einem späteren Zeitpunkt einstellbar ist, was für die Anwendung bei Prüfnadeln vorteilhaft ist.

In einer weiteren Ausführungsform der Erfindung ist vorgesehen, dass die metallische Legierung des Kernelements wenigstens eines der beiden Metalle 0,01 Gew.-% bis 0,5 Gew.-% Yttrium und 0,01 Gew.-% bis 0,5 Gew.-% Cer aufweist. Das Zulegieren von Yttrium und/oder Cer bevorzugt in den genannten Anteilen bietet eine weitere Möglichkeit, die Härte der metallischen Legierung und Aushärtbarkeit der metallischen Legierung durch die Temperaturbehandlung in vorteilhafter Weise zu steuern.

Darüber hinaus kann vorgesehen sein, dass die metallische Legierung des Kernelements 0,01 Gew.-% bis 15 Gew.-% Platin und/oder 0,01 Gew.-% bis 15 Gew.-% Iridium umfasst. Durch das Zulegieren von Platin und/oder Iridium können die mechanischen Eigenschaften der metallischen Legierung verbessert werden. Insbesondere werden die Elastizität und/oder die Härte des Kernelements, das aus einer solchen metallischen Legierung hergestellt wurde, verbessert.

Ferner kann vorgesehen sein, dass die metallische Legierung des Kernelements derart ist, dass diese eine Kornfeinung aufweist, um eine höhere Dehnbarkeit gegenüber mindestens 99,999 % reinem Rhodium zu besitzen. Durch eine Kornfeinung der metallischen Legierung gegenüber reinem Rhodium wird die Dehnbarkeit derart erhöht, dass die einfache und kostengünstige Verarbeitung der metallischen Legierung zu Drähten mit Durchmessern von 50 µm bis 100 µm ermöglicht wird.

Ferner kann vorgesehen sein, dass die metallische Legierung des Kernelements ein gleichkörniges Metallgefüge aufweist. Insbesondere bei gleichkörnigen Metallgefügen kommen die Vorteile der erfindungsgemäßen metallischen Legierung hinsichtlich der Formbarkeit zu dünnen Drähten in vorteilhafter Weise zum Tragen.

Es kann vorgesehen sein, dass die mittlere Korngröße der metallischen Legierung des Kernelements zwischen 0,01 µm und 2 µm liegt, vorzugsweise zwischen 0,02 µm und 0,5 um, besonders bevorzugt zwischen 0,05 µm und 0,1 µm. Diese Korngrößen ermöglichen eine besonders einfache Verarbeitung zu dünnen Drähten zur Ausbildung der Kernelemente erfindungsgemäßer Prüfnadeln.

In einer bevorzugten Ausführungsform der Prüfnadel ist vorgesehen, dass die metallische Legierung des Kernelements eine Härte von 300 HV bis 800 HV hat. Dieser Härtebereich ist für alle im Stand der Technik bekannten Prüfmethoden für Halbleiterelemente geeignet. Eine bevorzugte Ausführungsform der Prüfnadel sieht vor, dass die metallische Legierung des Kernelements im ziehharten Zustand eine Härte von 500 HV bis 750 HV hat und/oder in einem wärmebehandelten Zustand eine Härte von 400 HV bis 650 HV hat, um Halbleiterelemente mit Gold-Pads oder Aluminium-Pads über den distalen Kontaktabschnitt des Kernelements zu kontaktieren. Diese Härten sind sowohl zur Kontaktierung von Goldpads als auch von Aluminiumpads geeignet, wodurch die das Kernelement bildende metallische Legierung für Prüfnadeln breit einsetzbar ist.

Weiterhin kann vorgesehen sein, dass der distale Kontaktabschnitt des Kernelements konusartig ausgebildet ist. Eine Prüfnadel mit konusartigem, als Spitze ausgebildetem Kontaktabschnitt des Kernelements bildet eine bevorzugte Ausführungsform, da diese einfach herstellbar und in der Anwendung auf Prüfkarten bevorzugt wird.

In einer weiteren Ausführungsform ist vorgesehen, dass das Kernelement einen proximalen Kontaktabschnitt zur elektrischen Kontaktierung mit einer Prüfkarte aufweist. Das Kernelement der Prüfnadel muss über einen proximalen Kontaktabschnitt verfügen, der nicht von dem Mantelelement umfasst ist und elektrisch auf einer Prüfkarte kontaktierbar ist.

Eine weitere Ausführungsform der Prüfnadel sieht vor, dass das Kernelement der Prüfnadel einen Durchmesser von 20 µm bis 300 µm aufweist. Die das Kernelement der Prüfnadel bildende metallische Legierung ist geeignet, um Kernelemente für Prüfnadeln zu erzeugen, die einen breiten Anwendungsbereich abdecken. In einer bevorzugten Ausführungsform ist vorgesehen, dass das Kernelement der Prüfnadel einen Durchmesser von 60 µm bis 100 µm aufweist, um die Prüfnadel auf Prüfkarten gemäß der Anordnung im Cantilever-Test zu verwenden. Eine weitere bevorzugte Ausführungsform sieht vor, dass das Kernelement der Prüfnadel einen Durchmesser von 175 µm bis 225 µm aufweist, um die Prüfnadel auf Prüfkarten mit vertikal angeordneten Prüfnadeln zu verwenden.

In einer weiteren bevorzugten Ausführungsform ist vorgesehen, dass das Mantelelement das Kernelement in Umfangsrichtung vollständig umschließt und das Mantelelement das Kernelement in longitudinaler Richtung teilweise umschließt. Prüfnadeln mit dieser Geometrie lassen sich einfach und kostengünstig herstellen.

Eine weitere vorteilhafte Ausführungsform sieht vor, dass das elektrisch isolierende Mantelelement hüllrohrartig ausgebildet, insbesondere hüllrohrartig und auf das Kernelement aufschiebbar ist, um eine kraftschlüssige Verbindung zwischen Kernelement und Mantelelement auszubilden. Die separate Herstellung von isolierenden hüllrohrartigen Mantelelementen, die auf das Kernelement der Prüfnadel aufschiebbar sind, ermöglicht eine einfache und kostengünstige Produktionsweise von Prüfnadeln.

Alternativ ist vorgesehen, dass das elektrisch isolierende Mantelelement als Beschichtung ausgebildet ist, um eine stoffschlüssige Verbindung zwischen Kernelement und Mantelelement auszubilden. Beschichtungen lassen sich dünn, beispielsweise mit Schichtdicken von weniger als 6 um, realisieren, so dass den Anforderungen an hohe Packungsdichten von Prüfnadeln auf Prüfkarten durch Beschichtungen Rechnung getragen wird.

Es kann auch vorgesehen sein, dass ein elektrisch leitendes, schichtartiges Umfassungselement das elektrisch isolierende Mantelelement in Umfangsrichtung vollständig umschließt und in longitudinaler Richtung wenigstens teilweise umschließt, um Überkoppeln zwischen benachbart angeordneten Prüfnadeln entgegenzuwirken. Einem Überkoppeln zwischen benachbart angeordneten Prüfnadeln kann durch das Versehen der Prüfnadeln mit einem elektrisch leitenden, schichtartigen Umfassungselement effektiv entgegengewirkt werden. Überkoppeln wird verstärkt beobachtet bei hohen Packungsdichten von Prüfnadeln auf Prüfkarten. Durch das elektrisch leitende, schichtartige Umfassungselement wird der Signalfluss im Kernelement bei der Prüfung des Halbleiterelements abgeschirmt und dadurch weniger von benachbarten Störsignalen beeinflusst. Das elektrisch leitende, schichtartige Umfassungselement weist eine Schichtdicke von 1 bis 10 µm auf, bevorzugt von 5 µm.

Dabei kann vorgesehen sein, dass das elektrisch leitende, schichtartige Umfassungselement über eine elektrisch leitende Masseverbindung geerdet ist. Die Erdung des elektrisch leitenden, schichtartigen Umfassungselements dient einem schnellen Potentialausgleich beim Auftreten von Störströmen.

Eine weitere vorteilhafte Ausführungsform der Prüfnadel sieht vor, dass ein elektrisch isolierendes, schichtartiges Umschließungselement das elektrisch leitende, schichtartige Umfassungselement vollständig in Umfangsrichtung und wenigstens teilweise in longitudinaler Richtung umschließt, um das elektrisch leitende, schichtartige Umfassungselement abzuschirmen. Durch die Abschirmung des elektrisch leitenden, schichtartigen Umfassungselements werden schädliche Wirkungen bei gegenseitigem Kontakt der elektrisch leitenden Umfassungselemente verhindert und zuverlässige und stabile Messungen ermöglicht.

Eine Ausführungsform der erfindungsgemäßen Prüfnadel sieht dabei vor, dass das elektrisch isolierende Mantelelement und/oder das elektrisch isolierende, schichtartige Umschließungselement wenigstens einen Kunststoff, ausgewählt aus folgender Gruppe aufweist oder aus wenigstens einem Kunststoff, ausgewählt aus folgender Gruppe besteht: Polyethylen, Polypropylen, Polycarbonat, Polyimid, Polyesterimid, Polyamidimid, Polyurethanimid und Parylen. Diese Kunststoffe bieten Vorteile gegenüber anderen Kunststoffen hinsichtlich Dichtigkeit (der sogenannten "Pinholebeständigkeit"), elektrischer Durchschlagfestigkeit und thermischer Festigkeit. So verfügen die genannten Kunststoffe bei Beschichtungsstärken von beispielsweise 0,06 mm über Durchschlagsspannungen von wenigstens 170 V/µm und thermischen Festigkeiten von wenigstens 180 °C im Wärmeschocktest nach DIN 60851-6:2012.

Eine weitere Ausführungsform der erfindungsgemäßen Prüfnadel sieht vor, dass das elektrisch leitende, schichtartige Umfassungselement wenigstens einen Kunststoff, ausgewählt aus folgender Gruppe aufweist oder aus wenigstens einem Kunststoff, ausgewählt aus der folgenden Gruppe besteht: Polyethin, Polyphenylen, Polypyrrol, Polythiophen, Polychinolin und Polypyridin. Die genannten Polymere sind leitfähige Polymere, welche in ihrer Hauptkette über konjugierte Doppelbindungen verfügen und dadurch zur Ausbildung eines elektrisch leitfähigen, schichtartigen Umfassungselements geeignet sind.

Das elektrisch leitende Umfassungselement und das elektrisch isolierende Umschließungselement sind analog dem elektrisch isolierenden Mantelelement hüllrohrartig oder als Beschichtung ausgebildet.

Die oben genannte Aufgabe der vorliegenden Erfindung wird auch gelöst durch ein Verfahren zur Herstellung einer Prüfnadel zur elektronischen Prüfung von Halbleiterelementen, wobei die Prüfnadel ein elektrisch leitendes Kernelement umfasst, wobei das Kernelement aus einer metallischen Legierung aufgebaut ist und die Prüfnadel ein elektrisch isolierendes Mantelelement umfasst, wobei das Mantelelement das Kernelement bereichsweise umschließt, das Kernelement einen distalen Kontaktabschnitt aufweist, um die Prüfnadel auf dem Halbleiterelement elektrisch zu kontaktieren, umfassend die Schritte
a. Bereitstellen einer zylinderartigen Vorform aus einer metallischen Legierung, die das Kernelement bildet, wobei die metallische Legierung
   - wenigstens 67 Gew.-% Rhodium,
   - 0,1 Gew.-% bis 1 Gew.-% Zirkonium,
   - bis zu 1 Gew.-% Yttrium und
   - bis zu 1 Gew.-% Cer
   aufweist;
b. Ziehen der Vorform zu einem Draht;
c. Teilen des Drahtes in Drahtabschnitte, um das elektrisch leitende Kernelement der Prüfnadel auszubilden;
d. Aufbringen des elektrisch isolierenden Mantelelements auf das Kernelement;
e. Ausbilden eines konusartigen distalen Kontaktabschnitts des Kernelements.

Merkmale und Details, die in Zusammenhang mit der Prüfnadel beschrieben werden, gelten dabei auch in Zusammenhang mit dem Verfahren und umgekehrt.

Es ist sowohl möglich, das Mantelelement nach dem Teilen des Drahtes in Drahtabschnitte auf das Kernelement aufzubringen, als auch das Mantelelement vor dem Teilen des Drahtes in Drahtabschnitte auf das Kernelement aufzubringen.

Die erfindungsgemäßen Prüfnadeln sind in zahlreichen möglichen Kombinationen des erfindungsgemäßen Verfahrens herstellbar.

In einer bevorzugten Ausführungsform des erfindungsgemäßen Verfahrens ist vorgesehen, dass die metallische Legierung des Kernelements durch eine Temperaturbehandlung gehärtet wird, wobei die Härte durch die Temperaturbehandlung eingestellt wird. Der Erfindung liegt die überraschende Erkenntnis zugrunde, dass es durch das Zulegieren von Zirkonium zu Rhodium in den angegebenen Anteilen gelingt, eine härtbare metallische Legierung bereitzustellen, welche sowohl die notwendige Elastizität als auch die notwendige Härte aufweist, um als Kernelement für eine Prüfnadel verwendet zu werden. Weiterhin ist die metallische Legierung zuvor in einfacher Weise bearbeitbar, sodass die Herstellung des Kernelements der Prüfnadel ohne großen Aufwand durchführbar ist. Anschließend ist die Härte durch Glühen, beziehungsweise Tempern des gezogenen Drahtes beziehungsweise der vorgefertigten Prüfnadel einstellbar. Es ist eine Härte variabel einstellbar, die zum Prüfen der Kontakte von Goldpads oder von Aluminiumpads geeignet ist.

Dabei kann in bevorzugter Weise vorgesehen sein, dass die Temperaturbehandlung bei einer Temperatur zwischen 150 °C und 600 °C erfolgt und die Temperaturbehandlung über einen Zeitraum von zumindest 10 Minuten erfolgt. In bevorzugter Weise ist dabei vorgesehen, dass die Temperaturbehandlung in einem Bereich zwischen 200 °C und 400 °C durchgeführt wird.

Weiterhin ist vorgesehen, dass das Ausbilden des konusartigen distalen Kontaktabschnitts des Kernelements gemäß Schritt e. durch Ätzen erfolgt. Die das Kernelement bildende erfindungsgemäße metallische Legierung lässt sich gut ätzen, sodass der distale Kontaktabschnitt des Kernelements einfach mit wenig Aufwand zur Ausbildung einer Spitze geätzt werden kann und somit ein aufwändiges mechanisches Anspitzen der Prüfnadeln entfällt.

Im Rahmen des erfindungsgemäßen Verfahrens kann vorgesehen sein, dass nach Schritt d. ein elektrisch leitendes, schichtartiges Umfassungselement zumindest teilweise in longitudinaler Richtung und vollständig in Umfangsrichtung umschließend auf das elektrisch isolierende Mantelelement aufgebracht wird. Der Vorteil, die Prüfnadel mit einem elektrisch leitenden, schichtartigen Umfassungselement zu versehen besteht darin, dass dadurch dem Überkoppeln zwischen benachbart angeordneten Prüfnadeln bei der elektrischen Prüfung von Halbleiterelementen entgegen gewirkt wird. Überkoppeln kann insbesondere bei hohen Packungsdichten von Prüfnadeln auf Prüfkarten problematisch sein. Durch das elektrisch leitende, schichtartige Umfassungselement wird der Signalfluss im Kernelement bei der Prüfung des Halbleiterelements abgeschirmt und dadurch weniger von benachbarten Störsignalen beeinflusst.

In einer weiteren Ausführungsform des erfindungsgemäßen Verfahrens ist vorgesehen, dass nach dem Aufbringen des elektrisch leitenden, schichtartigen Umfassungselements ein elektrisch isolierendes, schichtartiges Umschließungselement zumindest teilweise in longitudinaler Richtung und vollständig in Umfangsrichtung umschließend auf dem elektrisch leitenden, schichtartigen Umfassungselement aufgebracht wird. Durch das Aufbringen des elektrisch isolierenden, schichtartigen Umschließungselements auf dem elektrisch leitenden, schichtartigen Umfassungselement wird das elektrisch leitende, schichtartige Umfassungselement zusätzlich abgeschirmt. Durch die Abschirmung des elektrisch leitenden, schichtartigen Umfassungselements werden schädliche Wirkungen bei gegenseitigem Kontakt der elektrisch leitenden Umfassungselemente verhindert und zuverlässige und stabile Messungen bei der elektrischen Prüfung von Halbleiterelementen ermöglicht.

In einer weiteren bevorzugten Ausführungsform des erfindungsgemäßen Verfahrens wird Schritt d. vor Schritt c. ausgeführt und das Mantelelement vollständig in longitudinaler Richtung auf das Kernelement aufgebracht. Durch das Aufbringen des elektrisch isolierenden Mantelelements auf das Kernelement vor dem Teilen des Drahtes in Drahtabschnitte lassen sich Vorläufer von Prüfnadeln in einfacher und rationaler Weise fertigen. Dabei kann vorgesehen sein, dass Schritt d. vor Schritt c. ausgeführt wird und zusätzlich das elektrisch leitende, schichtartige Umfassungselement und/oder das elektrisch isolierende, schichtartige Umschließungselement in longitudinaler Richtung auf das Kernelement aufgebracht wird/werden. Weiterhin ist denkbar, dass das Mantelelement in Schritt d. vollständig in longitudinaler Richtung und vollständig in Umfangsrichtung auf das Kernelement aufgebracht wird.

Oft ist es vorteilhaft, das Mantelelement zunächst vollständig aufzubringen und in einem nachfolgenden Schritt partiell zu entfernen, wobei das Mantelelement wenigstens teilweise von dem Kernelement abgetragen wird, um das Kernelement im Bereich des distalen und/oder proximalen Kontaktabschnitts freizulegen. Dies gilt analog für das elektrisch leitende Umfassungselement und das elektrisch isolierende Umschließungselement.

Vorzugsweise erfolgt das Abtragen durch mechanisches Abtragen und/oder ein Lösungsmittel. Es ist von der Auswahl des Kunststoffs oder der Kunststoffe für das Mantelelement abhängig, ob ein mechanisches Verfahren oder ein Lösungsmittel besser zur Abtragung geeignet ist.

Weiterhin kann vorgesehen sein, dass das Aufbringen des Mantelelements, des elektrisch leitenden Umfassungselements oder des elektrisch isolierenden Umschließungselements durch Abscheidung aus der Flüssigphase oder Gasphase erfolgt. Ob die Abscheidung aus der Flüssigphase oder Gasphase geeigneter ist, hängt von der Auswahl der Kunststoffe für das Mantelelement, das elektrisch leitende Umfassungselements und das elektrisch isolierende Umschließungselement ab.

Bei Abscheidung aus der Flüssigphase erfolgt das Aufbringen des Mantelelements, des elektrisch leitenden Umfassungselements oder des elektrisch isolierenden Umschließungselements in vorteilhafter Weise durch Lackieren in einem Tauchbad oder durch Spritzlackierung.

Bei Abscheidung aus der Gasphase erfolgt das Aufbringen des Mantelelements, des elektrisch leitenden Umfassungselements oder des elektrisch isolierenden Umschließungselements in vorteilhafter Weise durch Vakuumbeschichten.

In einer weiteren bevorzugten Ausführungsform des erfindungsgemäßen Verfahrens ist vorgesehen, dass das Kernelement im Bereich des proximalen und/oder distalen Kontaktabschnitts durch eine Wachsbeschichtung maskiert wird, um das Abtragen des Mantelelements, des elektrisch leitenden Umfassungselements oder des elektrisch isolierenden Umschließungselements zu erleichtern. Da Abtragungsverfahren für Kunststoffe auf Prüfnadeln oft nur unter hoher mechanischer Präzision oder mit Hilfe aggressiver Chemikalien möglich sind, kann eine vor der eigentlichen Beschichtung aufgetragene Wachsbeschichtung die Abtragung erleichtern, da die für das Mantelelement, das elektrisch leitende Umfassungselement oder das elektrisch isolierenden Umschließungselement gewählten Kunststoffe auf diese Weise keine stoffschlüssige Verbindung mit der metallischen Legierung des Kernelements eingehen können.

Weitere Maßnahmen und Vorteile der Erfindung ergeben sich aus den Ansprüchen, der nachfolgenden Beschreibung und den Zeichnungen. In den Zeichnungen ist die Erfindung in mehreren Ausführungsbeispielen dargestellt. Gleiche oder funktionsgleiche oder hinsichtlich ihrer Funktionen einander entsprechende Elemente werden dabei mit gleichen Bezugsziffern bezeichnet. Die Erfindung ist nicht auf die Ausführungsbeispiele beschränkt. Es zeigen:
- Fig. 1: einen Längsschnitt einer erfindungsgemäßen Prüfnadel umfassend ein elektrisch leitendes Kernelement und ein elektrisch isolierendes Mantelelement,
- Fig. 2: einen Längsschnitt einer weiteren Ausführungsform einer erfindungsgemäßen Prüfnadel umfassend ein elektrisch leitendes, schichtartiges Umfassungselement,
- Fig. 3: einen Querschnitt der erfindungsgemäßen Prüfnadel gemäß Fig. 1.
- Fig. 4: einen Querschnitt der erfindungsgemäßen Prüfnadel gemäß Fig. 2.
- Fig. 5: Temperatur-Härte-Kurven ausgewählter metallischer Legierungen auf Basis von Rhodium, (Absoluthärte) und
- Fig. 6: Temperatur-Härte-Kurven ausgewählter metallischer Legierungen auf Basis von Rhodium (relative Härteänderung).

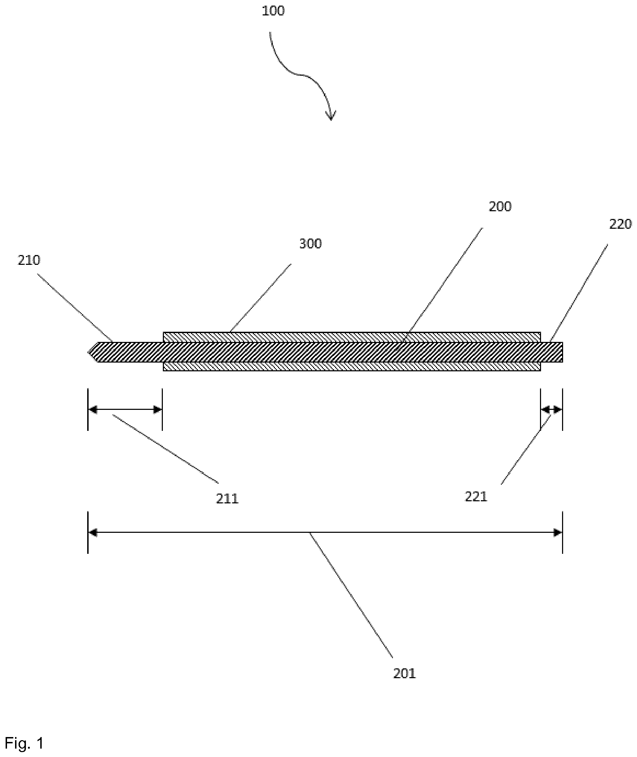

Die Figur 1 ist eine schematische Darstellung eines Längsschnitts einer erfindungsgemäßen Prüfnadel 100 umfassend ein elektrisch leitendes Kernelement 200 und ein elektrisch isolierendes Mantelelement 300. Die Prüfnadel 100 weist eine Länge 201 auf. Die Prüfnadel 100 umfasst einen distalen Kontaktabschnitt 210. Im Bereich des distalen Kontaktabschnitts 210 wird das Kernelement 200 nicht von dem Mantelelement 300 umfasst. Der Bereich des distalen Kontaktabschnitts 210, der Mantelelement-frei ist, weist eine Länge 211 auf. Die Prüfnadel 100 weist einen proximalen Kontaktabschnitt 220 auf. Im Bereich des proximalen Kontaktabschnitts 220 wird das Kernelement 200 nicht von dem Mantelelement 300 umfasst. Der proximale Kontaktabschnitt 220 weist eine Länge 221 auf. Die Länge 221 beträgt 60 bis 100 mm zum Einsatz der Prüfnadel im Cantilever-Test. Die Länge 220 beträgt 5 bis 40 mm zum Einsatz der Prüfnadel im Test mit vertikaler Anordnung der Prüfnadeln.

Der in Figur 1 gezeigte distale Kontaktabschnitt 210 ist im Bereich der Spitze konusartig ausgebildet. Der distale Kontaktabschnitt 210 dient der Kontaktierung des Halbleiterelements bei der Halbleiterprüfung. Der proximale Kontaktabschnitt 220 dient der Kontaktierung auf einer Prüfkarte, wobei auf einer Prüfkarte eine Vielzahl von Prüfnadeln 100 angeordnet ist.

Das erfindungsgemäße Kernelement 200 in Figur 1 weist eine metallische Legierung auf. Die metallische Legierung weist wenigstens 67 % Rhodium, 0,18 bis 1 Gew.-% Zirkonium, bis zu 1 Gew.-% Yttrium und bis zu 1 Gew.-% Cer auf. In einer bevorzugten Ausführungsform der Erfindung umfasst die metallische Legierung des Kernelements 200 wenigstens 97 Gew.-% Rhodium. In einer weiteren bevorzugten Ausführungsform der Erfindung umfasst die metallische Legierung des Kernelements 200 0,2 Gew.-% bis 0,6 Gew.-% Zirkonium.

Das elektrisch isolierende Mantelelement 300 ist in einer bevorzugten Ausführungsform der Erfindung hüllrohrartig ausgebildet und wird auf das Kernelement 200 aufgeschoben, um eine kraftschlüssige Verbindung zwischen Kernelement 200 und Mantelelement 300 herzustellen. Das elektrisch isolierende Mantelelement 300 verhindert das Auftreten von Kurzschlüssen bei der Prüfung von Halbleiterelementen, wenn mehrere Prüfnadeln 100 auf einer Prüfkarte dicht nebeneinander angeordnet vorliegen und eine gegenseitige Berührung der Prüfnadeln auftritt.

Das elektrisch isolierende Mantelelement 300 ist in einer alternativen bevorzugten Ausführungsform der Erfindung als Beschichtung ausgebildet, um eine stoffschlüssige Verbindung zwischen Kernelement 200 und Mantelelement 300 auszubilden. Die Ausbildung des Mantelelements 200 als Beschichtung erfolgt durch Abscheidung aus der Flüssigphase oder Gasphase. Bei Abscheidung aus der Flüssigphase erfolgt das Aufbringen des Mantelelements 300 in bevorzugter Weise durch Lackieren in einem Tauchbad oder Spritzlackierung. Bei Abscheidung aus der Gasphase erfolgt das Aufbringen des Mantelelements 300 bevorzugt durch Vakuumbeschichtung.

Bevorzugt erfolgt die Beschichtung auf einem Draht, der in einem späteren Herstellungsschritt in Drahtabschnitte zur Ausbildung des Kernelements 200 geteilt wird. Nach dem Teilen des beschichteten Drahtes in Drahtabschnitte wird die Beschichtung im Bereich des distalen Kontaktabschnitts 210 und im Bereich des proximalen Kontaktabschnitts 220 von dem Kernelement 200 entfernt. Das Entfernen des Mantelelements 300 im Bereich des distalen Kontaktabschnitts 210 und im Bereich des proximalen Kontaktabschnitts 220 erfolgt durch mechanisches Abtragen und/oder ein Lösungsmittel.

In einer bevorzugten Ausführungsform der Erfindung erfolgt das Abtragen durch ein Lösungsmittel, bevorzugt durch eine Säure, die die Beschichtung im Bereich des distalen Kontaktabschnitts 210 und im Bereich des proximalen Kontaktabschnitts 220 effektiv und rückstandsfrei entfernt, ohne das Kernelement 200 chemisch anzugreifen.

In einer weiteren bevorzugten Ausführungsform der Erfindung erfolgt eine Maskierung des Drahtes im Bereich des in einem nachfolgenden Schritt auszubildenden distalen Kontaktabschnitts 210 und im Bereich des in einem nachfolgenden Schritt auszubildenden proximalen Kontaktabschnitts 220 durch eine Wachsbeschichtung. Dadurch wird die Beschichtung, die das elektrisch isolierende Mantelelement 300 ausbildet, in einem nachfolgenden Herstellungsschritt in einfacher Weise entfernt.

Nach dem Aufbringen des Mantelelements 300, hüllrohrartig oder in Form einer Beschichtung, wird der distale Kontaktabschnitt 210 durch Schleifen oder Ätzen konusartig zur Bildung einer Spitze ausgeformt. In einer bevorzugten Ausführungsform der Erfindung erfolgt das Ausbilden der Spitze der Prüfnadel 100 durch Ätzen.

Zur Ausbildung des elektrisch isolierenden Mantelelements 300 werden Kunststoffe verwendet, die eine hohe Durchschlagsspannung und Temperaturbeständigkeit aufweisen und gut auf dem Kernelement 200 haften. Bevorzugt werden Polyethylen, Polypropylen, Polycarbonat, Polyimid, Polyesterimid, Polyamidimid, Polyurethanimid und Parylen.

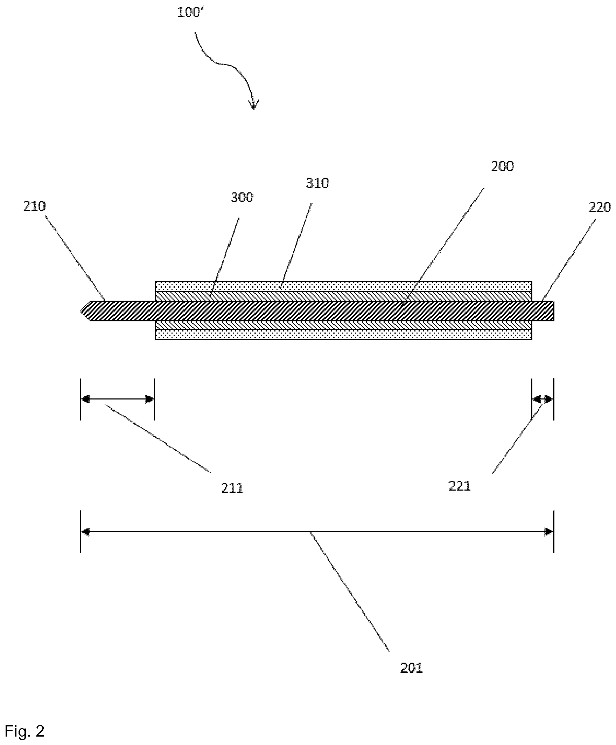

Die Figur 2 ist eine schematische Darstellung eines Längsschnitts einer weiteren Ausführungsform der erfindungsgemäßen Prüfnadel 100' umfassend ein elektrisch leitendes, schichtartiges Umfassungselement 310. Die Prüfnadel 100' weist eine Länge 201 auf. Die Prüfnadel 100' umfasst einen distalen Kontaktabschnitt 210. Im Bereich des distalen Kontaktabschnitts 210 wird das Kernelement 200 nicht von dem Mantelelement 300 und dem elektrisch leitenden, schichtartigen Umfassungselement 310 umfasst. Der Bereich des distalen Kontaktabschnitts 210, der Mantelelement-frei und frei von dem elektrisch leitenden, schichtartigen Umfassungselement 310 ist, weist eine Länge 211 auf. Die Prüfnadel 100' weist einen proximalen Kontaktabschnitt 220 auf. Im Bereich des proximalen Kontaktabschnitts 220 wird das Kernelement 200 nicht von dem Mantelelement 300 und dem elektrisch leitenden, schichtartigen Umfassungselement 310 umfasst. Der proximale Kontaktabschnitt 220 weist eine Länge 220 auf.

Das elektrisch leitende, schichtartige Umfassungselement 310 ist elektrisch leitend, um einem Überkoppeln zwischen benachbart angeordneten Prüfnadeln bei der Prüfung von Halbleiterelementen entgegenzuwirken. Bevorzugt ist das elektrisch leitende, schichtartige Umfassungselement 310 über eine elektrische Masseverbindung geerdet (nicht gezeigt), um einen raschen elektrischen Potentialausgleich bei der Prüfung von Halbleiterelementen herzustellen.

Das elektrisch leitende, schichtartige Umfassungselement 310 ist in einer Ausführungsform der Prüfnadel hüllrohrartig ausgebildet und wird auf das Mantelelement 300 aufgeschoben, um eine kraftschlüssige Verbindung zwischen Mantelelement 300 und elektrisch leitendem, schichtartigem Umfassungselement 310 auszubilden.

In einer alternativen Ausführungsform der Erfindung wird das elektrisch leitende, schichtartige Umfassungselement 310 als Beschichtung auf das Mantelelement 300 aufgebracht. Die Methoden zum Aufbringen der Beschichtung sind analog den beschriebenen Methoden zum Aufbringen des elektrisch isolierenden Mantelelements 300.

Zur Ausbildung des elektrisch leitenden, schichtartigen Umfassungselements 310 werden leitfähige Polymere verwendet, die über eine gute Leitfähigkeit und gleichzeitig eine hohe Temperaturbeständigkeit verfügen und gut auf dem Mantelelement 300 haften. Bevorzugt werden Polyethin, Polyphenylen, Polypyrrol, Polythiophen, Polychinolin und Polypyridin.

In einer weiteren Ausbildungsform der Erfindung ist vorgesehen, dass das elektrisch leitende, schichtartige Umfassungselement 310 von einem elektrisch isolierenden Umschließungselement umfasst wird (nicht gezeigt). Das elektrisch isolierende, schichtartige Umschließungselement schirmt das elektrisch leitende, schichtartige Umfassungselement 310 elektrisch und mechanisch ab. Es hat die Funktion, schädliche Wirkungen bei gegenseitigem Kontakt der elektrisch leitenden Umfassungselemente zu verhindern und zuverlässige und stabile Messungen bei der Kontaktierung von Prüfnadeln auf einem Halbleiterelement zu ermöglichen.

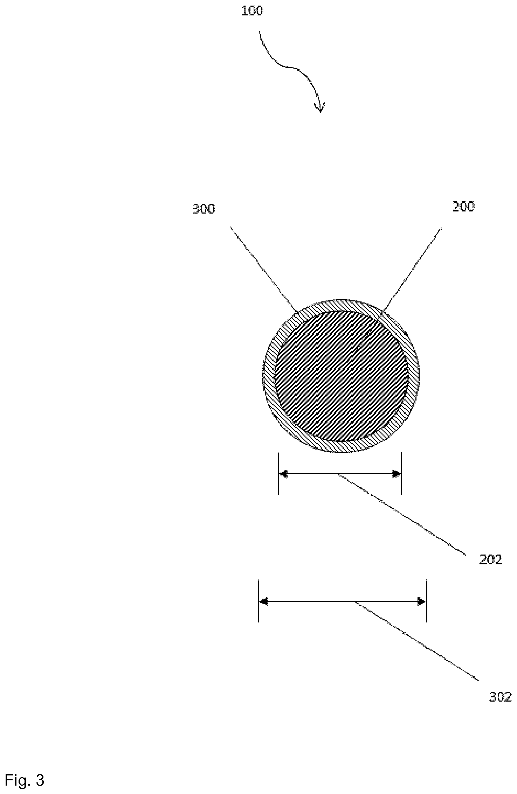

Die Figur 3 ist eine schematische Darstellung eines Querschnitts der erfindungsgemäßen Prüfnadel 100 gemäß Fig. 1. Die Prüfnadel 100 umfasst das elektrisch leitende Kernelement 200. Das elektrisch leitende Kernelement 200 weist einen Durchmesser 202 auf. Das elektrisch isolierende Mantelelement 300 weist einen Durchmesser 302 auf. Der Durchmesser 202 des Kernelements 200 beträgt bei erfindungsgemäßen Prüfnadeln 20 µm bis 300 µm. In einer bevorzugten Ausführungsform beträgt der Durchmesser 202 60 µm bis 100 µm. Die Prüfnadeln mit diesem Kernelement-Durchmesser eignen sich zur Verwendung im Cantilever-Test. In einer alternativen bevorzugten Ausführungsform beträgt der Kernelement-Durchmesser 202 175 µm bis 225 µm. Die Prüfnadeln mit diesem Kernelement-Durchmesser eignen sich zur Verwendung auf Prüfkarten mit vertikal angeordneten Prüfnadeln.

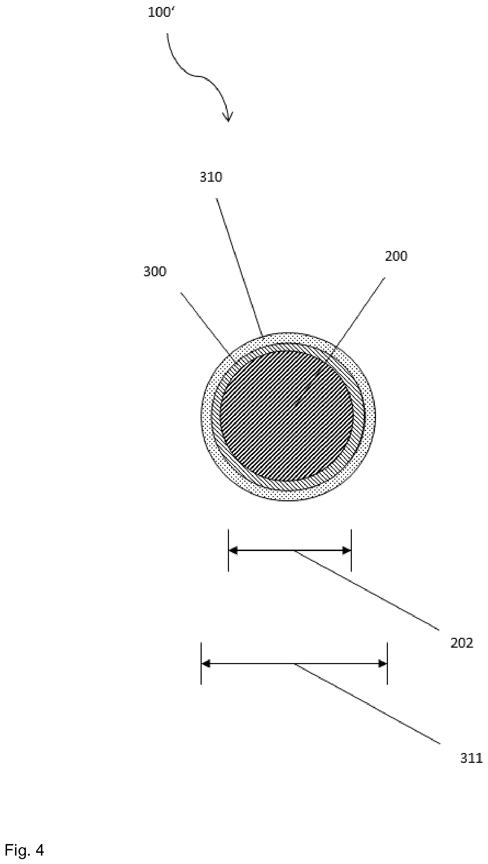

Die Figur 4 ist eine schematische Darstellung eines Querschnitts der erfindungsgemäßen Prüfnadel 100' gemäß Fig. 2. Das elektrisch leitende Kernelement 200 weist einen Durchmesser 202 auf. Das elektrisch leitende Kernelement 200 umfassend das elektrisch isolierende Mantelelement 300 und das elektrisch leitende, schichtartige Umfassungselement 310 weist einen Durchmesser 311 auf.

Bei einer Prüfkarte (nicht gezeigt) wird eine Vielzahl der in den Figuren 1 bis 4 dargestellten Prüfnadeln 100, 100' fest über einen Kartenkörper verbunden, um mit einem einzigen Aufdrücken der Prüfkarte eine Vielzahl von elektrischen Verbindungen (Kontaktpads) auf dem Halbleiterelement (nicht gezeigt) zu prüfen. Die entsprechenden Prüfverfahren sind dem Fachmann bekannt. Auf diese soll hier nicht näher eingegangen werden.

Die eingesetzten Prüfnadeln müssen über eine hohe Härte bei gleichzeitig guten Federeigenschaften verfügen. Die hohe Härte ist notwendig, da Prüfnadeln oft für millionenfache Prüfungen eingesetzt werden und dafür über eine geeignete Festigkeit verfügen müssen. Um den Kontakt zwischen der Prüfnadel und dem Halbleiterelement zu stabilisieren und die Abnutzung der Prüfnadel dabei zu minimieren, sind gute Federeigenschaften gefordert.

In Versuchen mit reinem Rhodium wurde die Herstellbarkeit von Kernelementen 200 für Prüfnadeln bis zu einem Durchmesser 202 des Kernelements 200 von 0,08 mm nachgewiesen. Allerdings zeigte das reine Rhodium ein zu plastisches Verhalten. Die hergestellten Prüfnadeln verformten sich bei zu geringem Druck auf die zu prüfende Oberfläche plastisch, also irreversibel.

Außerdem wurden verschiedene niedrig legierte metallische Legierungen auf Basis von Rhodium hergestellt und das Schmiedeverhalten untersucht. Alle untersuchten metallischen Legierungen auf Basis von Rhodium zeigten ein hervorragendes Verformungsverhalten.

Es wurden das Umformverhalten durch Schmiede- und Walzprozesse (warm/kalt) untersucht und die Aushärtbarkeit der metallischen Legierungen auf Basis von Rhodium bei Temperaturen bis zu 500 °C ermittelt.

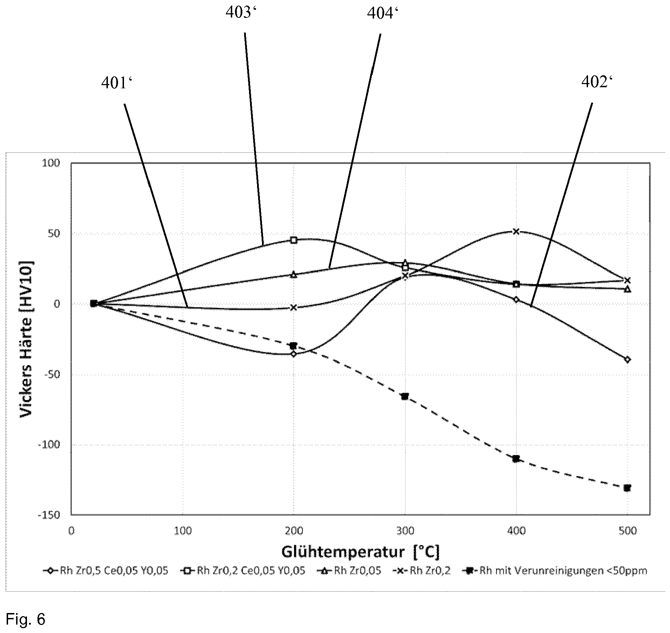

Alle metallischen Legierungen auf Basis von Rhodium ließen sich ohne Risse gut verformen und teilweise signifikant besser aushärten, was auf die Bildung von Ausscheidungen in den metallischen Legierungen auf Basis von Rhodium zurückzuführen ist. Die Zunahme der Härte betrug bis zu 51 HV ausgehend von einer Härte von 478 HV bei Raumtemperatur, wie Figur 6 verdeutlicht. Damit konnte gezeigt werden, dass für einzelne Vertreter der hier behandelten metallischen Legierungen auf Basis von Rhodium wichtige Grundvoraussetzungen für das Erfüllen der zuvor formulierten Anforderungen gegeben sind.

Geeignete Legierungskandidaten wurden mit dem Ziel verarbeitet, Drähte für Kernelemente 200 mit einem Durchmesser 202 (=D) von 0,080 mm herzustellen. Dafür wurde eine Legierung bestehend aus einer Vorlegierung sowie 99,9% reines Rhodium in einer Lichtbogenbeziehungsweise Ionenstrahlschmelze oder Elektronenstrahlschmelze hergestellt. In mehreren Durchgängen wurden die Barren bei 1200°C heiß geschmiedet. Nachfolgend wurden die Barren kalibergewalzt und Drähte im Heißzug an D = 0,3 mm und dann kalt an Durchmesser D = 0,080 mm für Kernelemente 202 gezogen, dazwischen mehrfach geglüht.

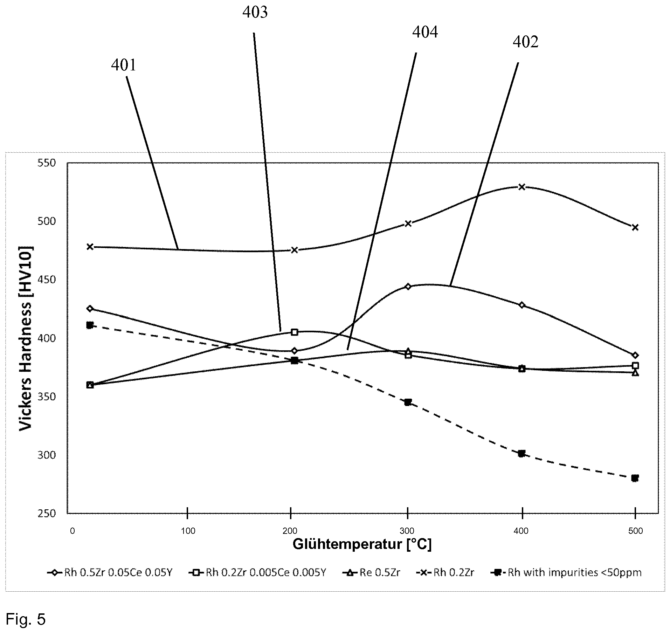

Es wurden mechanische Eigenschaften anhand von Zugversuchen und Härteanalysen im Schliff, die Verarbeitbarkeit durch die Häufigkeit von Drahtabrissen sowie die Ausbringung in Gramm in einem Stück, die Aushärtbarkeit mittels Temperatur-Härte-Kurven (Fig. 5 und 6) sowie die Leitfähigkeit durch eine 4-Punkt-Messung an einem 1000 mm langen Drahtstück beurteilt beziehungsweise gemessen.

**Tabelle 1: Die nachfolgende Tabelle 1 definiert eine Referenz A als reines Rhodium und vier verschiedene erfindungsgemäße metallische Legierungen auf Basis von Rhodium B bis E mit ihren jeweiligen Zusammensetzungen:**

| **Tabelle 1** | **Rh (Gew.%)** | **Zr (Gew.-%)** | **Ce (Gew.-%)** | **Y (Gew.-%)** |
|---|---|---|---|---|
| Rhodium A | 100 | 0 | 0 | 0 |
| Legierung B | Rest | 0,5 (5000ppm) | 0 | 0 |
| Legierung C | Rest | 0,2 | 0 | 0 |
| Legierung D | Rest | 0,5 | 0,05 | 0,05 |
| Legierung E | Rest | 0,2 | 0,05 | 0,05 |

Die Figur 5 dient dem Nachweis der Aushärtbarkeit erfindungsgemäßer metallischer Legierungen auf Basis von Rhoidum. Diese zeigen teilweise in den Versuchen die höchste Härte und stärkste Aushärtung infolge von Ausscheidungen. In dem genannten Legierungsbereich lassen sich noch weitere erfindungsgemäße metallische Legierungszusammensetzungen auf Basis von Rhodium finden. Die Grafik nach Figur 5 zeigt die Vickershärte (Vickers Hardness [HV10]) gegen die Temperungstemperatur beziehungsweise Glühtemperatur (Annealing Temperature [°C]) von vier bevorzugten metallischen Legierungen auf Basis von Rhodium. Die oberste Kurve 401 zeigt die Härte einer metallischen Legierung auf Basis von Rhodium mit 0,2 Gew.-% Zirkonium (Legierung C), die zweitoberste Kurve 402, die bei einer Temperung bei 400 °C die zweithöchste Härte aufweist, zeigt die Härte einer metallischen Legierung auf Basis von Rhodium mit 0,5 Gew.-% Zirkonium, 0,05 Gew.-% Yttrium und 0,05 Gew.-% Cer (Legierung D), die drittoberste Kurve 403, die bei einer Temperung bei 200 °C die zweithöchste Härte aufweist, zeigt die Härte einer metallischen Legierung auf Basis von Rhodium mit 0,2 Gew.-% Zirkonium, 0,005 Gew.-% Yttrium und 0,005 Gew.-% Cer (Legierung E) und die viertoberste Kurve 404, die bei einer Temperung bei 200 °C die niedrigste Härte aller metallischen Legierungen auf Basis von Rhodium aufweist, zeigt die Härte einer metallischen Legierung auf Basis von Rhodium mit 0,5 Gew.-% Zirkonium (Legierung B). Zusätzlich ist in Figur 5 die Härte von getempertem Rhodium in Reinform mit Verunreinigungen von weniger als 50 ppm gezeigt (gestrichelte Linie). Deutlich zeigt sich die Überlegenheit erfindungsgemäßer metallischer Legierungen auf Basis von Rhodium bei einer Temperung bei Temperaturen von 200° C und höheren Temperaturen. Die Temperung erfolgte jeweils über eine Glühdauer von 30 Minuten.

Es konnten signifikant verbesserte mechanische Eigenschaften in Versuchen für erfindungsgemäße metallische Legierungen auf Basis von Rhodium gemessen werden. Die Versuche wurden im ziehharten Zustand durchgeführt.

**Tabelle 2: Mechanische Eigenschaften von Rhodium und den metallischen Legierungen auf Basis von Rhodium RhZr0,2 und RhZr0,5. 0,025 g ist das Gewicht des Prüfstempels zur Bestimmung der Härte nach Vickers (HV0,025).**

| Material | Zugfestigkeit | Härte |
|---|---|---|
| | N/mm² | HV0,025 |
| Rh (Referenz) | 1570 | 520 |
| RhZr0,2 | 2200-3300 | 480-690 |
| RhZr0,5 | 2400-3090 | 490-650 |

Des Weiteren wurde festgestellt, dass die Zugabe von Zirkonium sowie Yttrium und Cer zu Rhodium zu einer deutlich verbesserten Verarbeitbarkeit von dünnen Querschnitten des Kernelements 200 bis 0,050 mm zur Folge hat.

**Tabelle 3: Verarbeitbarkeit erfindungsgemäßer metallischer Legierungen auf Basis von Rhodium und von Rhodium: Es wurde bei gleicher Herstellung die Anzahl der Drahtabrisse pro einhundert Meter gezogenem Draht für Kernelement 200 bestimmt. Zusätzlich ist das Gewicht des durchschnittlich hergestellten Drahts für Kernelement 200 angegeben, das heißt, wie schwer die gezogenen Drähte durchschnittlich werden konnten, bevor diese brachen.**

| Material | Drahtabrisse | Ausbringung |
|---|---|---|
| | pro 100m | g |
| Legierung A | 18 | <0,5 |
| Legierung B | 1 | >5 |
| Legierung C | 2 | >6 |
| Legierung D | 2 | >7 |
| Legierung E | 3 | >5 |

Die Aushärtbarkeit der vorgestellten metallischen Legierungen auf Basis von Rhodium wird in Figur 6 anhand von Härtemessungen bei verschiedenen Glühtemperaturen gezeigt. Die Figur 6 zeigt dabei die Änderung der Härte nach Vickers (HV) in Abhängigkeit von der Glühtemperatur in °C. Durch die nachträgliche Aushärtung kann die Endhärte nachträglich angehoben werden. Damit ist eine Umformung bei geringerer Festigkeit möglich, was sich positiv auf das Umformergebnis (beispielsweise die Geradheit der Prüfnadeln) auswirkt. Außerdem kann erfindungsgemäß durch die Einstellung der Härte die Anwendung des Materials für Goldpads beziehungsweise Aluminiumpads eingestellt werden.

Während bei reinem Rhodium die Härte bei einer Temperaturbehandlung abnimmt, kann bei den erfindungsgemäßen metallischen Legierungen auf Basis von Rhodium zunächst eine Umformung beziehungsweise eine Herstellung der Prüfnadeln 100, 100' erfolgen und anschließend die Härte durch eine nachgelagerte Temperaturbehandlung eingestellt beziehungsweise insbesondere erhöht werden.

In Experimenten konnte gezeigt werden, dass Zirkonium in den genannten Konzentrationsbereichen einen positiven Einfluss auf die Verarbeitbarkeit und Aushärtung von Rhodium hat. Durch das Zulegieren von Zirkonium (besonders mit 0,2 Gew.-% Zr und mit 0,5 Gew.-% Zr) können erfindungsgemäße metallische Legierungen auf Basis von Rhodium zu rissfreien Drähten für Kernelemente 200 mit Durchmessern von 0,080 mm verarbeitet werden. Die erreichbare Härte liegt bei über 620 HV. Die Verwendung als Prüfnadel 100, 100' erfordert eine Härte von 450 bis 500 HV und kann zugunsten einer optimierten Gradheit der Prüfnadel 100, 100' bei erfindungsgemäßen metallischen Legierungen auf Basis von Rhodium mittels eines nachgeschalteten Richt-Temper-Vorgangs eingestellt werden. Das Zulegieren von Yttrium und Cer führt ebenfalls zu einer Härtesteigerung und verbesserten Verarbeitbarkeit. Reines Rhodium, beziehungsweise Rhodium mit prozessbedingten Verunreinigungen von Platin und Iridium bis 100 ppm, zeigt diesen Effekt nicht (siehe Figuren 5 und 6). Die Verarbeitung zu rissfreien Drähten für Kernelemente 200 mit Durchmessern von 0,080 mm konnte mit Prüfnadeln 100, 100' aus einem solchen reinen Rhodium nicht zu einem serientauglichen Prozess geführt werden.

Biegeversuche an Drähten für Kernelemente 200 aus RhPt5Zr0,05 und RhIr6Zr0,05 zeigen, dass diese Materialkompositionen hervorragend geeignet sind, die besonderen Anforderungen an die Elastizität und Härte von Prüfnadeln 100, 100' zu erfüllen.

Insgesamt wurde ermittelt, dass es sich bei der erfindungsgemäßen Legierungsfamilie um eine hochleitfähige metallische Legierung auf Basis von Rhodium handelt, die sich gegenüber den am Markt etablierten Palladiumlegierungen durch eine hohe elektrische Leitfähigkeit auszeichnet.

Während die elektrische Leitfähigkeit von Palladium bei 9,26 10⁶ A/(V m) und von Platin bei 9,43 10⁶ A/(V m) liegt und die von Rhodium bei 23,3 10⁶ A/(V m) (40 %IACS), wurden für die Rhodiumlegierung mit 0,2 Gew.-% Zirkonium (Legierung C) eine elektrische Leitfähigkeit von 18,5 10⁶ A/(V m) (32 %IACS) gemessen, für die Rhodiumlegierung mit 0,5 Gew.-% Zirkonium, 0,05 Gew.-% Yttrium und 0,05 Gew.-% Cer (Legierung D) eine elektrische Leitfähigkeit von 16,8 10⁶ A/(V m) (29 %IACS), für die Rhodiumlegierung mit 0,2 Gew.-% Zirkonium, 0,005 Gew.-% Yttrium und 0,005 Gew.-% Cer (Legierung E) eine elektrische Leitfähigkeit von 18 10⁶ A/(V m) (31 %IACS) und für die Rhodiumlegierung mit 0,5 Gew.-% Zirkonium (Legierung B) eine elektrische Leitfähigkeit von 18 10⁶ A/(V m). Die Bestimmung der Leitfähigkeit erfolgte unter den folgenden Bedingungen: 4-Punkt-Messung mit U = 10 V und I = 10 mA. Berechnung des Widerstands über Messung des Spannungsabfalls. Für die Berechnung des %IACS-Werts wird die spezifische Leitfähigkeit ins Verhältnis gesetzt zu der spezifischen Leitfähigkeit von geglühtem Kupfer (100% IACS = 58 MS/m)

Während die Härte erfindungsgemäßer metallischer Legierungen auf Basis von Rhodium nach einer Temperaturbehandlung deutlich verbessert ist, ist die elektrische Leitfähigkeit gegenüber Palladium und Platin deutlich höher. Durch die erfindungsgemäßen metallischen Legierungen auf Basis von Rhodium wird es möglich, einen Draht für dünne Kernelemente 200 herzustellen, der besser als Palladium und/oder Platin zur Herstellung einer Prüfnadel 100, 100' geeignet ist, während ein entsprechender Draht für Kernelemente 200 aus reinem Rhodium nicht für den genannten Zweck herstellbar ist. Vorteilhaft kann bei den erfindungsgemäßen metallischen Legierungen auf Basis von Rhodium eine nachträgliche Härtung des Materials durch eine Temperaturbehandlung nach der Herstellung der Kernelemente 200 für Prüfnadeln 100, 100' erfolgen.

Das Zulegieren von geringen Mengen Yttrium, Cer und Zirkon zu Rhodium führt zu einer deutlich erhöhten Rekristallisationstemperatur und verbesserten mechanischen Eigenschaften. Dies kann vermutlich auf Ausscheidungen von Rhodium-Zirkonium-Phasen an den Korngrenzen zurückgeführt werden.

Nachfolgend wird die Leitfähigkeit für einige reine Elemente und Legierungen angegeben. Kupfer hat eine Leitfähigkeit von 59 10⁶ A/(V m), Rhodium 23,3 10⁶ A/(V m), Platin 9,43 10⁶ A/(V m), Palladium 9,26 10⁶ A/(V m), PtNi20, eine Legierung, die vor allem im asiatischen Raum als Standard verwendet wird, 3,77 10⁶ A/(V m) und Pd35Ag30Au10Pt10CuZn 5,8 10⁶ A/(V m), wobei letztere Legierung ein weit verbreitetes Prüfnadelmaterial ist.

Wie bereits zuvor begründet, ist die elektrische Leitfähigkeit von zentraler Bedeutung für die Funktion der Materialien in der elektrischen Kontakttechnik. Die erfindungsgemäßen metallischen Legierungen auf Basis von Rhodium haben eine hohe Leitfähigkeit im Vergleich zu den bekannten Legierungen für Prüfnadeln. Diese ist deutlich höher als die am Markt befindlichen Materialien PtNi, PdAgCu mit einer elektrischen Leitfähigkeit von weniger als 7 10⁶ A/(V m).

Für metallische Legierungen auf Basis von Rhodium mit weniger als jeweils 0,1 Gew.-% Zirkon sowie 100 ppm bis 1,1 Gew.-% Yttrium und Cer und dem Rest Rhodium und für metallische Legierungen auf Basis von Rhodium mit 1,1 Gew.-% Zirkon und dem Rest Rhodium konnten Drähte für Kernelemente 200, hergestellt wie beschrieben, nur mit häufigen Drahtabrissen von mindestens 17 Drahtabrissen pro 100 m Draht gezogen werden. Da ein Serienprozess wegen der häufigen Drahtabrisse für diese Legierungen nicht denkbar ist, wurde die maximale Ausbringung von Draht zu Draht nicht bestimmt.

Aufgrund von Überlegungen der Erfinder betreffend die Mischbarkeit und Legierbarkeit von Platin und Iridium zu Rhodium sowie den Materialeigenschaften solcher Mischungen und Legierungen wird gefolgert, dass ein Zulegieren von Platin und/oder Iridium zu erfindungsgemäßen metallischen Legierungen auf Basis von Rhodium die Materialeigenschaften in Summe positiv beeinflussen. Daher sind metallische Legierungen auf Basis von Rhodium mit 0,1 Gew.-% bis 1 Gew.-% Zirkonium sowie 0,1 Gew.-% bis 30 Gew.-% Platin und/oder 0,01 Gew.-% bis 30 Gew.-% Iridium weitere bevorzugte erfindungsgemäße metallische Legierungen auf Basis von Rhodium.

Die vollständige Mischbarkeit der Elemente Rhodium und Platin ab 4 Gew.-% Platin sowie die vollständige Mischbarkeit der Elemente Rhodium und Iridium ab 5 Gew.-% Iridium kann aus den entsprechenden binären Phasendiagrammen abgelesen werden und wird somit auch für die erfindungsgemäßen metallischen Legierungen auf Basis von Rhodium gefolgert.

Durch das Zulegieren von Platin wird wahrscheinlich das E-Modul verringert und die Elastizität erfindungsgemäßer metallischer Legierungen auf Basis von Rhodium erhöht. Dies ist eine vorteilhafte Eigenschaft für Kontaktteile, insbesondere Prüfnadeln, die einer häufigen Wechselbelastung ausgesetzt sind.

### Bezugszeichenliste

- 100, 100': Prüfnadel

- 200: Kernelement
- 201: Länge des Kernelements 200
- 202: Durchmesser des Kernelements 200
- 210: Distaler Kontaktabschnitt des Kernelements 200
- 211: Länge des distalen Kontaktabschnitts 210
- 220: Proximaler Kontaktabschnitt des Kernelements 200
- 221: Länge des proximalen Kontaktabschnitts 220

- 300: Mantelelement
- 302: Durchmesser der Prüfnadel 100
- 310: Elektrisch leitendes, schichtartiges Umfassungselement
- 311: Durchmesser der Prüfnadel 100'

- 401, 401': RhZr0,2 metallische Legierung auf Basis von Rhodium
- 402, 402': RhZr0,5Y0,05Ce0,05 metallische Legierung auf Basis von Rhodium

- 403, 403': RhZr0,2Y0,005Ce0,005 metallische Legierung auf Basis von Rhodium
- 404, 404': RhZr0,5 metallische Legierung auf Basis von Rhodium

## Patentansprüche

1. Prüfnadel (100, 100') zur elektronischen Prüfung von Halbleiterelementen, umfassend ein elektrisch leitendes Kernelement (200), wobei das Kernelement (200) aus einer metallischen Legierung aufgebaut ist und ein elektrisch isolierendes Mantelelement (300), wobei das Mantelelement (300) das Kernelement (200) bereichsweise umschließt, das Kernelement (200) einen distalen Kontaktabschnitt (210) zur elektrischen Kontaktierung mit dem Halbleiterelement aufweist, **dadurch gekennzeichnet, dass** die metallische Legierung des Kernelements (200) aufweist:
- wenigstens 67 Gew.-% Rhodium,
- 0,1 Gew.-% bis 1 Gew.-% Zirkonium,
- bis zu 1 Gew.-% Yttrium und
- bis zu 1 Gew.-% Cer.

2. Prüfnadel (100, 100') nach Anspruch 1, **dadurch gekennzeichnet, dass** die metallische Legierung des Kernelements (200) wenigstens 97 Gew.-% Rhodium umfasst.

3. Prüfnadel (100, 100') nach Anspruch 1 oder 2, **dadurch gekennzeichnet, dass** die metallische Legierung des Kernelements (200) 0,1 Gew.-% bis 0,6 Gew.-% Zirkonium umfasst.

4. Prüfnadel (100, 100') nach einem der vorhergehenden Ansprüche, **dadurch gekennzeichnet, dass** die metallische Legierung des Kernelements (200) wenigstens eines der beiden Metalle aufweist:
- 0,01 Gew.-% bis 0,5 Gew.-% Yttrium und
- 0,01 Gew.-% bis 0,5 Gew.-% Cer.

5. Prüfnadel (100, 100') nach einem der vorhergehenden Ansprüche, **dadurch gekennzeichnet, dass** die metallische Legierung des Kernelements (200) derart ist, dass diese eine Kornfeinung aufweist, um eine höhere Dehnbarkeit gegenüber mindestens 99,999 % reinem Rhodium zu besitzen.

6. Prüfnadel (100, 100') nach einem der vorhergehenden Ansprüche, **dadurch gekennzeichnet, dass** die metallische Legierung des Kernelements (200) im ziehharten Zustand eine Härte von 500 HV bis 750 HV hat und/oder in einem wärmebehandelten Zustand eine Härte von 400 HV bis 650 HV hat, um Halbleiterelemente mit Gold-Pads oder Aluminium-Pads über den distalen Kontaktabschnitt des Kernelements zu kontaktieren.

7. Prüfnadel (100, 100') nach einem der vorangehenden Ansprüche, **dadurch gekennzeichnet, dass** das Mantelelement (300) das Kernelement (200) in Umfangsrichtung vollständig umschließt und das Mantelelement (300) das Kernelement (200) in longitudinaler Richtung teilweise umschließt.

8. Prüfnadel (100, 100') nach einem der vorangehenden Ansprüche, **dadurch gekennzeichnet, dass** ein elektrisch leitendes, schichtartiges Umfassungselement (310) das elektrisch isolierende Mantelelement (300) in Umfangsrichtung vollständig umschließt und in longitudinaler Richtung wenigstens teilweise umschließt, um Überkoppeln zwischen benachbart angeordneten Prüfnadeln entgegenzuwirken.

9. Prüfnadel (100, 100') nach einem der vorangehenden Ansprüche, **dadurch gekennzeichnet, dass** der distale Kontaktabschnitt (210) konusartig ausgebildet ist.

10. Prüfnadel nach einem der vorangehenden Ansprüche, **dadurch gekennzeichnet, dass** das Kernelement (200) einen proximalen Kontaktabschnitt (220) zur elektrischen Kontaktierung mit einer Prüfkarte aufweist.

11. Verfahren zur Herstellung einer Prüfnadel (100, 100') zur elektronischen Prüfung von Halbleiterelementen, wobei die Prüfnadel (100, 100') ein elektrisch leitendes Kernelement (200) umfasst, wobei das Kernelement (200) aus einer metallischen Legierung aufgebaut ist und die Prüfnadel (100, 100') ein elektrisch isolierendes Mantelelement (300) umfasst, wobei das Mantelelement (300) das Kernelement (200) bereichsweise umschließt, das Kernelement (200) einen distalen Kontaktabschnitt (210) aufweist, um die Prüfnadel (100, 100') auf dem Halbleiterelement elektrisch zu kontaktieren, umfassend die Schritte:
a. Bereitstellen einer zylinderartigen Vorform aus einer metallischen Legierung, die das Kernelement (200) bildet, wobei die metallische Legierung
- wenigstens 67 Gew.-% Rhodium,
- 0,1 Gew.-% bis 1 Gew.-% Zirkonium,
- bis zu 1 Gew.-% Yttrium und
- bis zu 1 Gew.-% Cer
aufweist;
b. Ziehen der Vorform zu einem Draht;
c. Teilen des Drahtes in Drahtabschnitte, um das elektrisch leitende Kernelement (200) der Prüfnadel (100, 100') auszubilden;
d. Aufbringen des elektrisch isolierenden Mantelelements (300) auf das Kernelement (200);
e. Ausbilden eines konusartigen distalen Kontaktabschnitts (210) des Kernelements.

12. Verfahren nach Anspruch 11, **dadurch gekennzeichnet, dass** die metallische Legierung des Kernelements (200) durch eine Temperaturbehandlung gehärtet wird, wobei die Härte durch die Temperaturbehandlung eingestellt wird.

13. Verfahren nach Anspruch 12, **dadurch gekennzeichnet, dass** die Temperaturbehandlung bei einer Temperatur zwischen 150 °C und 600 °C erfolgt und die Temperaturbehandlung über einen Zeitraum von zumindest 10 Minuten erfolgt.

14. Verfahren nach einem der vorangehenden Ansprüche 11 bis 13, **dadurch gekennzeichnet, dass** das Ausbilden des konusartigen distalen Kontaktabschnitts (210) des Kernelements (200) gemäß Schritt e. durch Ätzen erfolgt.

15. Prüfnadel (100, 100') zur elektronischen Prüfung von Halbleiterelementen nach wenigstens einem der Ansprüche 1 bis 10, hergestellt nach wenigstens einem der Ansprüche 11 bis 14.

## Claims

1. Test needle (100, 100') for electronic testing of semiconductor elements, comprising an electrically conductive core element (200), whereby the core element (200) is made up of a metallic alloy and an electrically insulating jacket element (300), whereby the jacket element (300) surrounds regions of the core element (200), the core element (200) comprises a distal contact section (210) for electrical contacting to the semiconductor element, **characterised in that** the metallic alloy of the core element (200) comprises:
- at least 67% by weight rhodium,
- 0.1% by weight to 1% by weight zirconium,
- up to 1 % by weight yttrium, and
- up to 1 % by weight cerium.

2. Test needle (100, 100') according to claim 1, **characterised in that** the metallic alloy of the core element (200) comprises at least 97% by weight rhodium.

3. Test needle (100, 100') according to claim 1 or 2, **characterised in that** the metallic alloy of the core element (200) comprises 0.1 % by weight to 0.6% by weight zirconium.

4. Test needle (100, 100') according to any one of the preceding claims, **characterised in that** the metallic alloy of the core element (200) comprises at least one of the two metals:
- 0.01 % by weight to 0.5% by weight yttrium and
- 0.01 % by weight to 0.5% by weight cerium.

5. Test needle (100, 100') according to any one of the preceding claims, **characterised in that** the metallic alloy of the core element (200) is appropriate such that same has a grain refinement in order to possess a higher ductility with respect to at least 99.999% pure rhodium.

6. Test needle (100, 100') according to any one of the preceding claims, **characterised in that** the metallic alloy of the core element (200), in hard-drawn condition, has a hardness ranging from 500 HV to 750 HV and/or, in a heat-treated condition, has a hardness ranging from 400 HV to 650 HV, in order to contact semiconductor elements with gold pads or aluminium pads via the distal contact section of the core element.

7. Test needle (100, 100') according to any one of the preceding claims, **characterised in that** the jacket element (300) fully surrounds the core element (200) in circumferential direction and **in that** the jacket element (300) partially surrounds the core element (200) in longitudinal direction.

8. Test needle (100, 100') according to any one of the preceding claims, **characterised in that** an electrically conductive, layer-like enclosure element (310) fully surrounds the electrically insulating jacket element (300) in circumferential direction and surrounds it at least partially in longitudinal direction in order to counteract any over-coupling between test needles that are arranged adjacent to each other.

9. Test needle (100, 100') according to any one of the preceding claims, **characterised in that** the distal contact section (210) is designed to be conical.

10. Test needle according to any one of the preceding claims, **characterised in that** the core element (200) comprises a proximal contact section (220) for electrical contacting to a probe card.

11. Method for the production of a test needle (100, 100') for electronic testing of semiconductor elements, whereby the test needle (100, 100') comprises an electrically conductive core element (200), whereby the core element (200) is made up of a metallic alloy, and the test needle (100, 100') comprises an electrically insulating jacket element (300), whereby the jacket element (300) surrounds regions of the core element (200), the core element (200) comprises a distal contact section (210) for electrical contacting of the test needle (100, 100') on the semiconductor element, comprising the steps of:
a. Providing a cylindrical preform made of a metallic alloy that forms the core element (200), whereby the metallic alloy comprises
- at least 67% by weight rhodium,
- 0.1% by weight to 1% by weight zirconium,
- up to 1 % by weight yttrium, and
- up to 1 % by weight cerium;
b. Drawing the preform into a wire;
c. Separating the wire into wire sections in order to form the electrically conductive core element (200) of the test needle (100, 100');
d. Applying the electrically insulating jacket element (300) onto the core element (200);
e. Forming a conical distal contact section (200) of the core element.

12. Method according to claim 11, **characterised in that** the metallic alloy of the core element (200) is hardened by means of a temperature treatment, whereby the hardness is adjusted by means of the temperature treatment.

13. Method according to claim 12, **characterised in that** the temperature treatment takes place at a temperature between 150°C and 600°C and the temperature treatment takes place over a period of time of at least 10 minutes.

14. Method according to any one of the preceding claims 11 to 13, **characterised in that** the formation of the conical distal contact section (210) of the core element (200) takes place according to step e. by means of etching.

15. Test needle (100, 100') for electronic testing of semiconductor elements according to at least one of the claims 1 to 10, produced according to at least one of the claims 11 to 14.

## Revendications

1. Aiguille de test (100, 100') pour le test électronique d'éléments de semi-conducteurs, comprenant un élément de noyau (200) conducteur électrique, dans lequel l'élément de noyau (200) est constitué d'un alliage métallique, et un élément d'enveloppe (300) isolant électrique, dans lequel l'élément d'enveloppe (300) entoure l'élément de noyau (200) par tronçons, l'élément de noyau (200) présente un tronçon de contact (210) distal pour le contact électrique avec l'élément de semi-conducteur, **caractérisée en ce que** l'alliage métallique de l'élément de noyau (200) présente :
- au moins 67 % en poids de rhodium,
- 0,1 % en poids à 1 % en poids de zirconium,
- jusqu'à 1 % en poids d'yttrium et
- jusqu'à 1 % en poids de cérium.

2. Aiguille de test (100, 100') selon la revendication 1, **caractérisée en ce que** l'alliage métallique de l'élément de noyau (200) comprend au moins 97 % en poids de rhodium.

3. Aiguille de test (100, 100') selon la revendication 1 ou 2, **caractérisée en ce que** l'alliage métallique de l'élément de noyau (200) comprend 0,1 % en poids à 0,6 % en poids de zirconium.

4. Aiguille de test (100, 100') selon l'une des revendications précédentes, **caractérisée en ce que** l'alliage métallique de l'élément de noyau (200) comprend au moins un des deux métaux :
- 0,01 % en poids à 0,5 % en poids d'yttrium et
- 0,01 % en poids à 0,5 % en poids de cérium.

5. Aiguille de test (100, 100') selon l'une des revendications précédentes, **caractérisée en ce que** l'alliage métallique de l'élément de noyau (200) est de telle sorte que celui-ci présente une finesse de grain pour posséder une ductilité supérieure par rapport à au moins 99,999 % de rhodium pur.

6. Aiguille de test (100, 100') selon l'une des revendications précédentes, **caractérisée en ce que** l'alliage métallique de l'élément de noyau (200) étiré dur a une dureté de 500 HV à 750 HV et/ou traité à chaud, a une dureté de 400 HV à 650 HV pour mettre en contact des éléments de semi-conducteurs avec des pastilles d'or ou d'aluminium sur le tronçon de contact distal de l'élément de noyau.

7. Aiguille de test (100, 100') selon l'une des revendications précédentes, **caractérisée en ce que** l'élément d'enveloppe (300) entoure complètement l'élément de noyau (200) dans le sens périphérique et l'élément d'enveloppe (300) entoure partiellement l'élément de noyau (200) dans le sens longitudinal.

8. Aiguille de test (100, 100') selon l'une des revendications précédentes, **caractérisée en ce qu'**un élément d'entourage (310) conducteur électrique et en couches entoure complètement l'élément d'enveloppe (300) isolant électrique dans le sens périphérique et l'entoure au moins partiellement dans le sens longitudinal, pour agir contre un surcouplage entre des aiguilles de test voisines.

9. Aiguille de test (100, 100') selon l'une des revendications précédentes, **caractérisée en ce que** le tronçon de contact (210) distal est conique.

10. Aiguille de test (100, 100') selon l'une des revendications précédentes, **caractérisée en ce que** l'élément de noyau (200) présente un tronçon de contact (220) proximal pour le contact électrique avec une carte de test.

11. Procédé de fabrication d'une aiguille de test (100, 100') pour le test électronique d'éléments de semi-conducteurs, dans lequel l'aiguille de test (100, 100') comprend un élément de noyau (200) conducteur électrique, dans lequel l'élément de noyau (200) est constitué d'un alliage métallique, et l'aiguille de test (100, 100') comprend un élément d'enveloppe (300) isolant électrique, dans lequel l'élément d'enveloppe (300) entoure l'élément de noyau (200) par tronçons, l'élément de noyau (200) présente un tronçon de contact (210) distal pour le contact électrique de l'aiguille de test (100, 100') sur l'élément de semi-conducteur, comprenant les étapes :
a. fourniture d'une pré-forme cylindrique dans un alliage métallique qui forme l'élément de noyau (200), dans lequel l'alliage métallique présente
- au moins 67 % en poids de rhodium,
- 0,1 % en poids à 1 % en poids de zirconium,
- jusqu'à 1 % en poids d'yttrium et
- jusqu'à 1 % en poids de cérium ;
b. étirage de la préforme en un fil ;
c. partage du fil en tronçons de fil pour former l'élément de noyau (200) conducteur électrique de l'aiguille de test (100, 100') ;
d. application de l'élément d'enveloppe (300) isolant électrique sur l'élément de noyau (200) ;
e. formation d'un tronçon de contact (210) distal conique de l'élément de noyau.

12. Procédé selon la revendication 11, **caractérisé en ce que** l'alliage métallique de l'élément de noyau (200) est durci par un traitement en température, dans lequel la dureté est réglée par le traitement en température.

13. Procédé selon la revendication 12, **caractérisé en ce que** le traitement en température a lieu à une température entre 150°C et 600°C et le traitement en température a lieu sur une période d'au moins 10 minutes.

14. Procédé selon l'une des revendications 11 à 13, **caractérisé en ce que** la formation du tronçon de contact (210) distal conique de l'élément de noyau (200) selon l'étape e. a lieu par corrodage.

15. Aiguille de test (100, 100') pour le test électronique d'éléments de semi-conducteurs selon au moins l'une des revendications 1 à 10, fabriquée selon au moins l'une des revendications 11 à 14.
